# EUROPEAN PATENT SPECIFICATION

(11) **EP 2 922 378 B1**
(45) Date of publication and mention of the grant of the patent: **16.08.2017**
(21) Application number: 12888301.4
(22) Date of filing: 16.11.2012
(51) Int. Cl.: H05K 13/04

(54) **WORK DEVICE AND COMPONENT MOUNTING DEVICE**
ARBEITSVORRICHTUNG UND KOMPONENTENMONTAGEVORRICHTUNG
DISPOSITIF DE TRAVAIL ET DISPOSITIF DE MONTAGE DE COMPOSANT

(43) Date of publication of application: 23.09.2015
(73) Proprietor: Fuji Machine Mfg. Co., Ltd., Chiryu-shi Aichi 472-8686 (JP)
(72) Inventor: KIDO Takashi, Chiryu-shi Aichi 472-8686 (JP); FUJITA Masatoshi, Chiryu-shi Aichi 472-8686 (JP); NAGATA Ryo, Chiryu-shi Aichi 472-8686 (JP); KAINUMA Makoto, Chiryu-shi Aichi 472-8686 (JP)
(74) Representative: Grünecker Patent- und Rechtsanwälte PartG mbB
(86) International application number: PCT/JP2012/079750
(87) International publication number: WO 2014/076809

(56) References cited:
- JP-A- H0 766 596
- JP-A- H09 148 790
- JP-A- 2000 174 498
- JP-A- 2006 109 635
- JP-A- 2006 147 640
- JP-A- 2009 033 783
- JP-A- 2009 303 432
- JP-A- 2011 103 313
- JP-A- 2012 150 758

## Description

### Technical Field

The present invention relates to a working apparatus in which a working member performs an extension movement, abuts against a working target, and performs a predetermined work, and to a component mounting machine which is included in a category of this type of working apparatus.

### Background Art

As equipment which produces a printed circuit board on which a plurality of components are mounted, a solder paste printing machine, a component mounting machine, a board detecting machine, or a reflow machine is employed, and in general, these machines are linked to each other by a board conveyance device and a board production line is built. Among these machines, the component mounting machine is provided with the board conveyance device, a component supply device, and a component transfer device, and mounts the components on a printed circuit board. The component transfer device is provided with a mounting head and a nozzle holder which are driven in an orthogonal 2-axes direction, and a mounting nozzle which is held by the nozzle holder and performs an extension movement downward. The mounting nozzle sucks the components to a sucking portion of a tip end by using a negative pressure, performs an extension movement, and mounts the component by releasing suction while making the components abut against the printed circuit board. It is preferable that the extension speed of the mounting nozzle increases in order to finish a component mounting work during a short period of time. However, in contrast, an impact load when the components abut against the printed circuit board increases and work reliability deteriorates. Many technologies both for achieving short period of time for the component mounting work and for ensuring the work reliability are disclosed starting with PTL 1.

An electronic component mounting method in PTL 1 lowers a suction nozzle (mounting nozzle) up to a target position at which a variable error is subtracted by the thickness of an electronic component or a curve of the printed circuit board, makes the suction nozzle approach the printed circuit board by reducing a lowering speed of the suction nozzle from the target position, and releases the suction by making the suction nozzle stop being lowered when collision with the printed circuit board of the electronic component is detected. Accordingly, it is described that it is possible to eliminate damage of the electronic component by the collision, and to realize reliable bonding between the electronic component and the mounting position of the printed circuit board.

A further electronic component mounting method and a power conversion controller are disclosed in PTL 2 and PTL 3, respectively.

### Citation List

### Patent Literature

PTL 1: Japanese Patent No. 4172902
PTL 2: JP H07 66596 A
PTL 3: JP 2006 109635 A

### Summary of Invention

### Technical Problem

However, an example of a requirement for a component mounting machine in recent years is correspondence to a small size of a final product which is represented by a smart phone. Specifically, the component is considerably small and thin, and it is required for an integrated circuit component (an IC, an LSI, or the like) which is made of a low height chip capacitor or an ultrathin wafer to be mounted. In these components, an impact load or a positional error which is allowed during the mounting is more severe than that in the related art, and there is a concern that the component is damaged, or the accuracy of a mounting position deteriorates when following the related art.

In this regard, the technology in PTL 1 is preferable in that it is possible to reduce the speed in the middle of lowering a mounting nozzle and to reduce the impact load, but an adverse effect that the mounting nozzle is vibrated is generated. In other words, the mounting nozzle vibrates by a reaction force which is generated when the lowering speed of the mounting nozzle is considerably changed, and the accuracy of the mounting position deteriorates. In particular, when the mounting nozzle is made to perform an extension movement at a high speed until right before the component abuts against the printed circuit board, it is required for the speed to be substantially reduced right before mounting is performed, thereby, a large reaction force is inevitably generated, which is not preferable. In this manner, it is not allowed to simply increase an extension speed, acceleration, and deceleration of the mounting nozzle in line with the technology in the related art.

This type of problem is not limited to the component mounting machine, and is common to a working apparatus in which a working member performs an extension movement, abuts against a working target, and performs a predetermined work.

The present invention is to solve this problem of the above-described related art, and to provide a working apparatus in which working time can be shortened by increasing an extension speed of a working member, and the accuracy of a working position can be ensured while reducing an impact load when the working member abuts against a working target. Furthermore, the present invention is to provide a component mounting machine in which time for mounting a component with respect to a low height component or an ultrathin component can also be shortened, and the accuracy of a mounting position can be ensured while reducing the impact load when the member abuts against a printed circuit board.

### Solution to Problem

The invention according to Claim 1 to solve the above-described problem provides a working apparatus, including: a base member; a working member which is held by the base member to be extendable, performs an extension movement from a reference position of the base member, and performs a predetermined work by being abutted against a positioned working target at a working position; a driving portion which outputs driving power and drives the extension movement of the working member; and a work control portion which controls at least one of a current position and an extension speed of the working member to be variable by controlling the driving power of the driving portion. The work control portion includes a switching setting unit which sets a switching position in the middle of a stroke length of which the working member extends to the working position from the reference position, and sets a coarse movement driving region from the reference position to the switching position and a low speed driving region from the switching position to the working position, a coarse movement control unit which controls vibration generated by at least one of the working member and the base member by a reaction force when the working member performs the extension movement while controlling the extension speed of the working member to be high in the coarse movement driving region, a low speed control unit which controls the working member to extend to the working position after the speed becomes equal to or less than an allowable speed that is appropriate for the predetermined work while controlling the extension speed of the working member to be low in the low speed driving region, and a switching adjustment unit which adjusts the extension speed and acceleration of the working member to be smoothly changed when the working member passes through the switching position, further wherein, the coarse movement control unit includes a terminal state control unit, or a linear matrix inequality unit, which controls the extension speed and the acceleration when the working member passes through the switching position to match the switching value, the coarse movement control unit includes a vibration control filter unit that selectively attenuates a frequency component including the intrinsic frequency in the driving power of the driving portion based on an intrinsic frequency of the vibration which is determined depending on a structure of the working member and the base member, and the switching adjustment unit sets in advance a switching value which delivers the extension speed and the acceleration when the working member passes through the switching position from the coarse movement control unit to the low speed control unit.

The invention according to Claim 2 provides the working apparatus described in Claim 1, in which the switching adjustment unit sets the extension speed when the working member passes through the switching position to be equal to or less than the allowable speed.

The invention according to Claim 3 provides the working apparatus described in Claim 1 or 2, in which the work control portion further includes a prior computation unit which is determined by the switching setting unit, the coarse movement control unit, the low speed control unit, and the switching adjustment unit, computes and holds at least one of a position command profile which shows a relationship between elapsed time after the working member starts the extension movement and the current position of the working member, and a speed command profile which shows a relationship between the elapsed time and the extension speed of the working member in advance, and uses the profiles in performing a control.

The invention according to Claim 4 provides a component mounting machine which is the working apparatus described in any one of Claims 1 to 3, including: a board holding device which positions and holds a printed circuit board; a component supply device which supplies a plurality of components; and a component transfer device which includes a mounting nozzle which sucks the component from the component supply device and mounts the component on the held printed circuit board, a nozzle holder which holds the mounting nozzle to be able to perform the extension movement, and a nozzle driving mechanism which drives the extension movement of the mounting nozzle, in which the base member is the nozzle holder, the working member is the mounting nozzle, and the driving portion is the nozzle driving mechanism, and in which, by considering the working target as the held printed circuit board and the working position as a surface of the printed circuit board, the predetermined work is a component mounting work in which the mounting nozzle abuts against the surface of the positioned printed circuit board and mounts the component.

The invention according to Claim 5 provides the component mounting machine described in Claim 4, in which the switching setting unit sets the switching position at a working position when the stroke length becomes minimized in consideration of the stroke length which changes depending on at least one of a component height dimension that is different according to the type of the component and deformation of the positioned printed circuit board.

### Advantageous Effects of Invention

In the invention of the working apparatus according to Claim 1, the working member sets the switching position in the middle of the stroke length which extends from the reference position to the working position, and divides the switching position into the coarse movement driving region and the low speed driving region, vibration is controlled while controlling the working member at a high speed in the coarse movement driving region, the working member is made to abut against the working target after the speed becomes equal to or less than the allowable speed while controlling the working member at a low speed in the low speed driving region, and the extension speed and the acceleration when the working member passes through the switching position are adjusted to be smoothly changed. Therefore, it is possible to increase the average extension speed of the working member and to shorten the working time. In addition, since the extension speed of the working member becomes equal to or less than the allowable speed when the working member abuts against the working target, the impact load is reduced and the predetermined work is appropriately performed. Furthermore, since the vibration of the working member is controlled in the coarse movement driving region, and additionally, the reaction force which is generated as the extension speed and the acceleration are smoothly changed at the switching position is small, it is possible to ensure the accuracy of the working position without being influenced by the vibration.

Also, in the invention according to Claim 1, the coarse movement control unit includes the vibration control filter unit that selectively attenuates the frequency component which includes the intrinsic frequency of the vibration in the driving power of the driving portion. Therefore, even when the working member is made to perform the extension movement at a high speed, the vibration of the frequency component which includes the intrinsic frequency is controlled, and it is possible to more reliably ensure the accuracy of the working position by considerably controlling the vibration.

Furthermore, in the invention according to Claim 1, the switching adjustment unit sets the switching value of the extension speed and the acceleration at the switching position in advance, and the coarse movement control unit includes the terminal state control unit which realizes the switching value, or a linear matrix inequality unit. Therefore, even when a control method is changed at the switching position, the extension speed and the acceleration do not become discontinuous, an excessive reaction force is not generated, and it is possible to more reliably ensure the accuracy of the working position by considerably controlling the vibration.

In the invention according to Claim 2, the switching adjustment unit sets the extension speed when the working member passes through the switching position to be equal to or less than the allowable speed. Therefore, the extension speed when the working member abuts against the working target becomes equal to or less than the allowable speed, and the impact load is reliably reduced.

In the invention according to Claim 3, the prior computation unit can compute and hold at least one of the position command profile and the speed command profile in advance, and can use the profiles in performing the control. According to this, the computation for obtaining the profile after the working member starts the extension movement is not necessary, and a delay of the control due to computation processing is not generated. In addition, it is easy to control a feedback by setting the profile to be a target value and by actually measuring the position or the speed of the working member. Accordingly, an operation control with high accuracy is performed.

In the invention of the component mounting machine according to Claim 4, a remarkable effect in the component mounting work by the mounting nozzle is generated. In other words, with respect to the low height component or the ultrathin component which has a stricter allowable impact load or positional error than that in the related art, it is also possible to shorten the component mounting time by the extension movement at a high speed in the coarse movement driving region. In addition, since it is possible to reduce the impact load when the component abuts against the printed circuit board, the component mounting work is appropriately performed, and there is no concern that the component is damaged. Furthermore, since the vibration of the mounting nozzle is suppressed, it is possible to ensure the accuracy of the mounting position of the component.

In the invention according to Claim 5, the switching position is set at the working position when the stroke length becomes minimized in consideration of the stroke length which changes depending on at least one of the component height dimension and deformation of the printed circuit board. Accordingly, since it is possible to ensure the minimum low speed driving region, and to set most of the stroke length as the coarse movement driving region, it is possible to shorten the component mounting time to be minimized by increasing the average extension speed of the mounting nozzle to be maximized.

### Brief Description of Drawings

[Fig. 1] Fig. 1 is a perspective view illustrating the entire configuration of a component mounting machine of an embodiment.
[Fig. 2] Fig. 2 is a schematic side view illustrating a state right before a component transfer device of the component mounting machine of the embodiment starts a component mounting work.
[Fig. 3] Fig. 3 is a functional block diagram illustrating a control function of a work control portion.
[Fig. 4] Fig. 4 is a view illustrating a speed command profile which is obtained by differentiating a position command profile.
[Fig. 5] Fig. 5 is a flow chart illustrating a computation processing content of the position command portion.
[Fig. 6] Fig. 6 is a view illustrating frequency properties of three types of vibration control filter units and overall frequency properties when all of the three types are combined and used.
[Fig. 7] Fig. 7 is a waveform view illustrating a method of a basic experiment for confirming effects of the vibration control filter unit of a position control portion 62 and a torque control portion.
[Fig. 8] Fig. 8 is a frequency spectrum view illustrating an example of an operation of the vibration control filter unit of the torque control portion.
[Fig. 9] Fig. 9 is a waveform view illustrating a result of the basic experiment for confirming the effects of the vibration control filter unit.

### Description of Embodiments

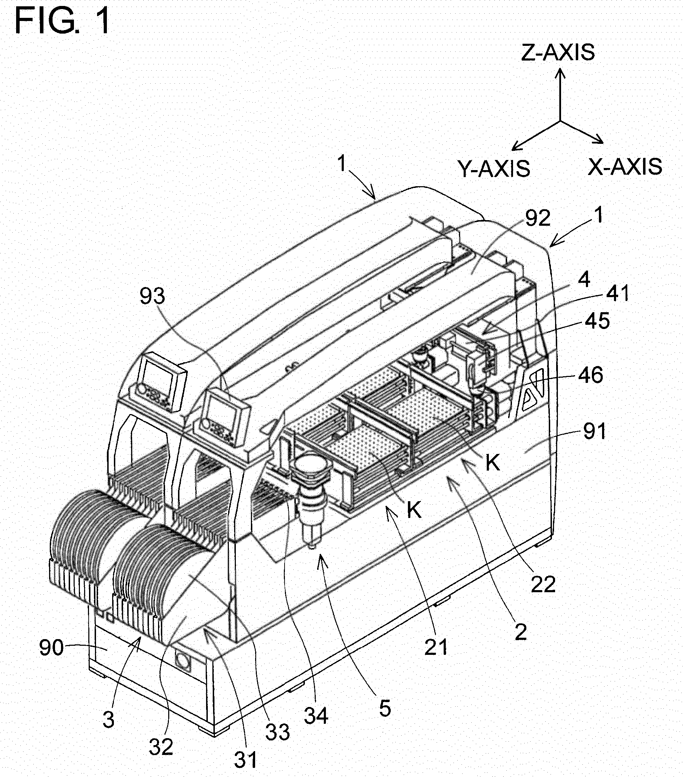

A component mounting machine 1 according to an embodiment of the present invention will be described with reference to Figs. 1 to 9. The component mounting machine 1 is included in a category of a working apparatus in which a working member performs an extension movement, abuts against a working target, and performs a predetermined work. Fig. 1 is a perspective view illustrating the entire configuration of the component mounting machine 1 of the embodiment. In Fig. 1, two component mounting machines 1 which are aligned in parallel on a common base 90 are illustrated. The component mounting machine 1 has a configuration in which a board conveyance device 2, a component supply device 3, a component transfer device 4, a component camera 5, and a control computer which is not illustrated are assembled to an apparatus stand 91 (reference numeral is given only to the component mounting machine 1 on a front right side). As illustrated in an XYZ coordinate axis at an upper right part of Fig. 1, a horizontal width direction (a direction which is oriented toward a lower right part from an upper left part of a paper surface of Fig. 1) of the component mounting machine 1 is set to be an X-axis direction, a horizontal longitudinal direction (a direction which is oriented toward a lower left part from the upper right part of the paper surface of Fig. 1) of the component mounting machine 1 is set to be a Y-axis direction, and a vertical height direction is set to be a Z-axis direction.

The board conveyance device 2 is provided around an intermediate part of the component mounting machine 1 in a longitudinal direction. The board conveyance device 2 is a so-called double conveyer type device in which a first conveyance device 21 and a second conveyance device 22 are aligned in parallel. The board conveyance device 2 conveys in, positions, and conveys out two printed circuit boards K in the X-axis direction by operating the two printed circuit boards K in parallel. The first and the second conveyance devices 21 and 22 respectively include a pair of conveyor rails (reference numeral thereof is omitted) which are provided in parallel being separated from each other on the apparatus stand 91 and parallel to the X-axis direction. Each conveyor rail forms a conveyance path, and a conveyor belt (reference numeral thereof is omitted) is constructed to be rotatable. The conveyor belt conveys the printed circuit board K which is loaded by the rotation. Each of the first and the second conveyance devices 21 and 22 includes a board holding device (not illustrated) which positions and holds the printed circuit board K conveyed to a component mounting position by pushing up the printed circuit board K from the apparatus stand 91 side.

The component supply device 3 is a feeder type device. The component supply device 3 is provided in a front portion (front left side of Fig. 1) of the component mounting machine 1 in the longitudinal direction. The component supply device 3 has a configuration in which a plurality of cassette type feeders 31 are aligned in parallel in the X-axis direction on the apparatus stand 91. Each cassette type feeder 31 includes a main body 32 which is attached to be attachable to and detachable from the apparatus stand 91, a supply reel 33 which is mounted to be rotatable or attachable and detachable on a rear portion (front side of the component mounting machine 1) of the main body 32, and a component supply section 34 which is provided at a tip end (near the center of the component mounting machine 1) of the main body 32. The supply reel 33 is a medium which supplies the component. A carrier tape (not illustrated) which holds a plurality of components with a certain interval is wound around the supply reel 33. A tip end of the carrier tape is drawn out to the component supply section 34, and different components are supplied to every carrier tape.

The component transfer device 4 is a so-called an XY robot type device which can move in the X-axis direction and in the Y-axis direction. The component transfer device 4 is installed across an upper part of the component supply device 3 of the front portion from a rear portion (far right side of Fig. 1) of the component mounting machine 1 in the longitudinal direction. The component transfer device 4 is configured of a head driving mechanism 41 (most of the head driving mechanism 41 is omitted in Fig. 1) and a component mounting head 45. The head driving mechanism 41 drives the component mounting head 45 in the X-axis direction and in the Y-axis direction.

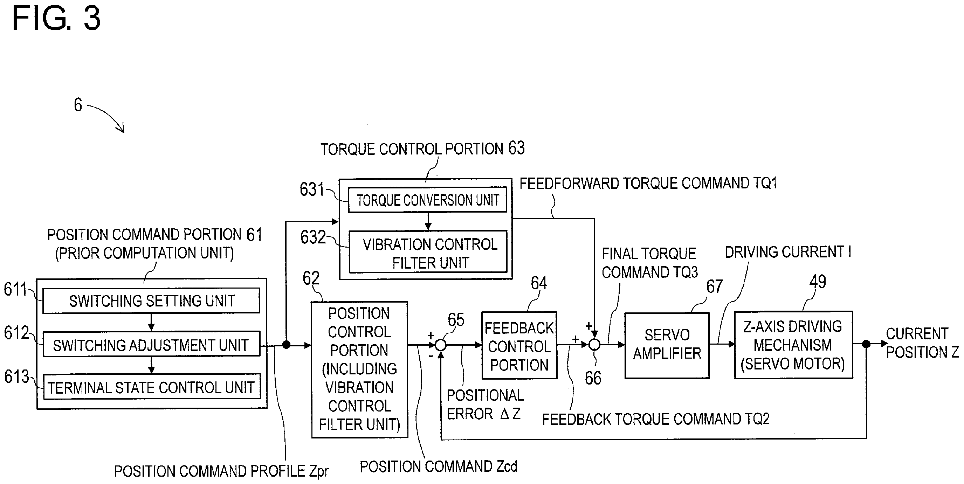

A nozzle holder 46 is provided below the component mounting head 45. The nozzle holder 46 downwardly holds a plurality of mounting nozzles 47 which suck and mount the component by using a negative pressure. The component mounting head 45 includes an R-axis rotation driving mechanism (not illustrated) which rotates and drives the nozzle holder 46 around a Z axis. Furthermore, the component mounting head 45 includes a Z-axis driving mechanism 49 (reference numeral thereof is illustrated in Fig. 3) which makes the selected mounting nozzle 47 perform an extension movement and a degeneration movement in the Z-axis direction, and a θ-axis rotation driving mechanism (not illustrated) which rotates and drives the selected mounting nozzle 47 around the Z axis. A servo motor is used as a driving source in the Z-axis driving mechanism 49, and the Z-axis driving mechanism 49 is driven by a driving current I which is output from a servo amplifier 67 (illustrated in Fig. 3).

The component camera 5 is a device which images a state when the mounting nozzle 47 of the component transfer device 4 sucks the component. The component camera 5 is installed on the apparatus stand 91 in the vicinity of the component supply section 34 of the component supply device 3. The control computer, which is not illustrated, is connected to the board conveyance device 2, the component supply device 3, the component transfer device 4, and the component camera 5 by a communication cable. The control computer performs computation or determination by acquiring necessary information from each device 2 to 5, and controls the movements of each device 2 to 5 by generating appropriate commands. In order that an operator confirms information output from the control computer, and further, performs necessary operations or settings, a display operating device 93 is installed in a front upper portion of a cover 92 of the upper portion.

In the component mounting machine 1 of the embodiment, a series of operations from suction of the components to mounting is performed as follows. In other words, first, the head driving mechanism 41 of the component transfer device 4 moves the component mounting head 45 to an upper part of the component supply section 34 of the cassette type feeder 31 to which mounted component P is supplied. Next, the Z-axis driving mechanism 49 is operated, and the mounting nozzle 47 performs the extension movement downward from a reference position. The mounting nozzle 47 sucks the component P with a sucking portion 48 at the lower part by using a negative pressure, and returns to the reference position by the degeneration movement. After the mounting nozzle 47 performs the degeneration movement or in the middle of the degeneration movement, the head driving mechanism 41 moves the component mounting head 45 to an upper part of the component camera 5. The component camera 5 images the state where the mounting nozzle 47 sucks the component, and determines whether or not the component is mounted based on imaging data.

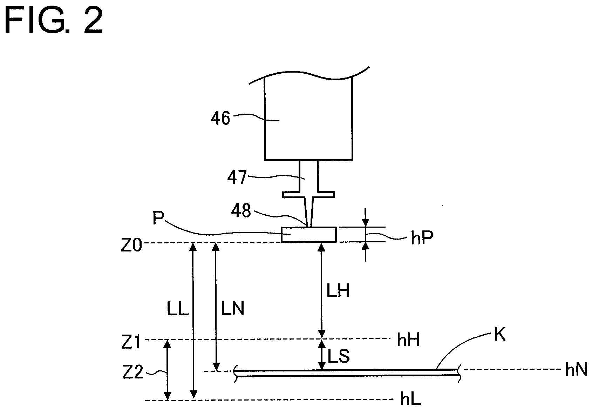

In most of cases, the component may be mounted, and the head driving mechanism 41 moves the component mounting head 45 to an upper part of the positioned printed circuit board K. Next, the component transfer device 4 starts the component mounting work. Fig. 2 is a schematic side view illustrating a state right before the component transfer device 4 of the component mounting machine 1 of the embodiment starts the component mounting work. In Fig. 2, for a simple description, only one mounting nozzle 47 among the plurality of mounting nozzles 47 which are held by the nozzle holder 46 is illustrated. A position Z of the mounting nozzle 47 in the Z-axis direction is a reference position Z0. In addition, in the description of the embodiment, the position Z of the mounting nozzle 47 is illustrated as a lower end position of the sucked component P. In addition, an example in which the printed circuit board K is not deformed, and a surface thereof is held at a defined position hN is illustrated. In Fig. 2, a distance LN between a lower end of the component P and the surface of the printed circuit board K is a stroke length L. In other words, when the mounting nozzle 47 performs the extension movement downward only with the stroke length LN, the component P abuts against the surface of the printed circuit board K and is mounted.

The nozzle holder 46 corresponds to a base member of the present invention, the mounting nozzle 47 corresponds to the working member of the present invention, and the Z-axis driving mechanism 49 corresponds to the driving portion of the present invention. In addition, the component mounting work corresponds to the predetermined work of the present invention, the printed circuit board K corresponds to the working target of the present invention, and the position Z of the mounting nozzle 47 when the component P abuts against the surface of the printed circuit board K corresponds to a working position Z2 of the present invention.

In Fig. 2, when the printed circuit board K is deformed, for example, the surface on a cambered part of the printed circuit board K is raised to a position hH, and the surface on a domed part of the printed circuit board K is lowered to a position hL. In response to this, the working position Z2 changes, and the stroke length L changes from a minimum value LH to a maximum value LL. In addition, the stroke length L also changes depending on a component height dimension hP of the component P.

In order to reduce an influence of the impact load when the component P abuts against the surface of the printed circuit board K, an elastic structure which is not illustrated is employed in the mounting nozzle 47. In other words, the mounting nozzle 47 is configured of a nozzle main body portion which performs the extension movement from the nozzle holder 46, and a nozzle tip end portion which sucks the component P that is held via an elastic member in the nozzle main body portion. For this reason, when the Z-axis driving mechanism 49 exceeds the stroke length L and makes the nozzle main body portion perform the extension movement, the elastic member is deformed after the component P abuts against the printed circuit board K. According to this action, an excessive load does not act on the printed circuit board K, and damage is not generated.

In the related art, when the extension speed of the mounting nozzle 47 increases for shortening mounting work time, great acceleration and deceleration are necessary. In this case, vibration is generated to the mounting nozzle 47 and the nozzle holder 46 by the reaction force when the mounting nozzle 47 performs the extension movement. Here, as illustrated in Fig. 1, the mounting nozzle 47 and the nozzle holder 46 are cantilever-supported by the head driving mechanism 41 via the component mounting head 45. Therefore, the mounting nozzle 47 performs pitching vibration generally in a YZ plane. Accordingly, the sucking portion 48 of a tip end of the mounting nozzle 47 vibrates in the Y-axis direction and in the Z-axis direction, and the accuracy of the mounting position deteriorates.

In order to suppress deterioration of the accuracy of the mounting position, in the embodiment, a work control portion 6 is provided in the control computer which controls the component mounting work. Fig. 3 is a functional block diagram illustrating a control function of the work control portion 6. The work control portion 6 performs a feedforward control with respect to the driving power (torque) of the Z-axis driving mechanism 49, and performs a feedback control by comparing and checking the current position Z of the mounting nozzle 47 with the position command Zcd. As illustrated in the drawing, the work control portion 6 is configured of a position command portion 61, a position control portion 62, a torque control portion 63, and a feedback control portion 64. The position command portion 61 includes a switching setting unit 611, a switching adjustment unit 612, and a terminal state control unit 613 of the present invention. The position control portion 62 includes a vibration control filter unit of the present invention. The torque control portion 63 includes a torque conversion unit 631 and a vibration control filter unit 632 of the present invention.

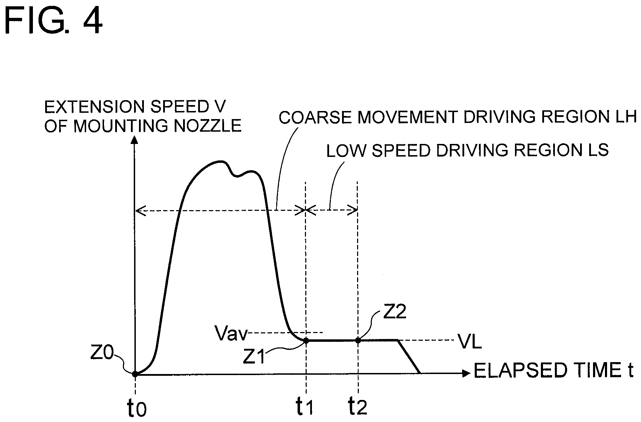

The work control portion 6 obtains a position command profile Zpr which shows a relationship between elapsed time t after the mounting nozzle 47 starts the extension movement and the current position Z of the mounting nozzle 47 by computation, and holds and uses the position command profile Zpr in the control. Fig. 4 is a view illustrating a speed command profile which is obtained by differentiating the position command profile Zpr. The speed command profile is actually not used in the control of the work control portion 6, but is illustrated for the description in order to make it easy to understand the content of the control.

In Fig. 4, a horizontal axis illustrates the elapsed time t after the mounting nozzle 47 starts the extension movement, and a vertical axis illustrates an extension speed V of the mounting nozzle 47. Points Z0, Z1, and Z2 of Fig. 4, respectively correspond to a state where the current position Z of the mounting nozzle 47 in Fig. 2 is at a reference position Z0, a switching position Z1, and a working position Z2 (the current position Z is expressed at a lower end position of the component P as described above). A region from time t0 to t1 corresponds to a coarse movement driving region LH, which will be described later, and a region from the time t1 to t2 corresponds to a low speed driving region LS, which will be described later.

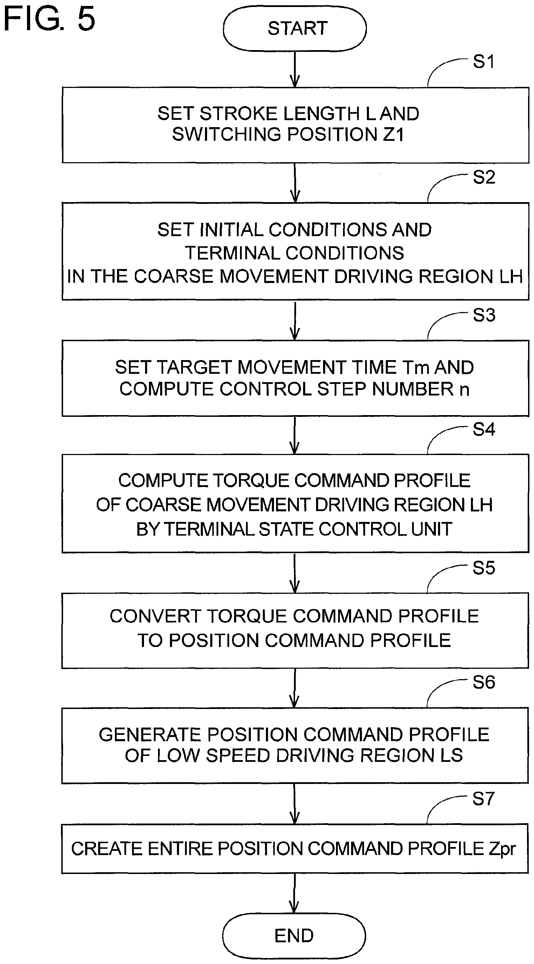

The position command portion 61 of the work control portion 6 creates the position command profile Zpr specifically according to a computation processing order illustrated in Fig. 5. Fig. 5 is a flow chart illustrating a computation processing content of the position command portion 61. In step S1 of Fig. 5, the switching setting unit 611 of the position command portion 61 sets the stroke length L with which the mounting nozzle 47 performs the extension movement to be equivalent to LL. At this time, the switching setting unit 611 considers the component height dimension hP of the component P, and considers a distance to the position hL at which the printed circuit board K is lowered while the stroke length L becomes the maximum value LL. In addition, the switching setting unit 611 sets the switching position at the working position when the stroke length L becomes the minimum value LH. Specifically, the position hH which is an upper limit of the cambered part of the printed circuit board K in Fig. 2 becomes the switching position Z1. Accordingly, the coarse movement driving region LH (the same as the minimum value LH) from the reference position Z0 to the switching position Z1, and the low speed driving region LS from the switching position Z1 to the working position Z2, are set. In Fig. 2, the low speed driving region LS when the surface of the printed circuit board K is held at the defined position hN is illustrated.

In the next step S2, the position command portion 61 sets initial conditions and terminal conditions when the mounting nozzle 47 performs the extension movement in the coarse movement driving region LH. The position command portion 61 sets position Z=reference position Z0, speed V=0, and acceleration A=0 as the initial conditions when the mounting nozzle 47 starts extension from the reference position Z0. In addition, the switching adjustment unit 612 of the position command portion 61 sets position Z=switching position Z1, speed V=low speed VL, and acceleration A=0 as the terminal conditions when the mounting nozzle 47 passes through the switching position Z1. The low speed VL is set to be equal to or less than a speed Vav at which the impact load generated to the component P is suppressed to be sufficiently small and which is applied in the component mounting work, and is set to be a speed which is allowed with respect to the low height component or the ultrathin component.

In the next step S3, the position command portion 61 sets target movement time Tm, which is necessary when the mounting nozzle 47 moves in the coarse movement driving region LH. Here, the control of the extension movement of the mounting nozzle 47 is performed with an interval of a control period Ts of the work control portion 6. Therefore, it is possible to compute a control step number n by the following formula.

### Control step number n=(target movement time Tm/control period Ts)

In the next step S4, the terminal state control unit 613 of the position command portion 61 computes a torque value which is necessary for every control period Ts in the coarse movement driving region LH. The n torque values with the interval of the control period Ts which are time-serially aligned in parallel are torque command profiles. The terminal state control unit 613 is a mathematical computation technique which computes the torque command profile that satisfies the above-described initial conditions, the terminal conditions, and the control step number n, and performs the feedforward control. In addition, a mass (size of inertia) of the mounting nozzle 47 which is used in computation or characteristics of the servo motor of the Z-axis driving mechanism 49 are held by the terminal state control unit 613 in advance.

The detailed description of the terminal state control unit 613 is disclosed, for example, in a thesis "Nanoscale servo control for a galvanometer using a terminal state control" in Journal of the Institute of Electrical Engineers of Japan, Part D, Vol. 129 No. 9. In addition, instead of the terminal state control unit 613, a known linear matrix inequality unit (LMI unit), which is another similar mathematical computation technique, may be used.

In the next step S5, the position command portion 61 converts the obtained torque command profile, and generates the position command profile of the coarse movement driving region LH. This conversion computation is performed basically by a division of the inertia and a time integration computation in two stages.

In the next step S6, the position command portion 61 computes the position command for every control period Ts in the low speed driving region LS on a condition that speed V=low speed VL and acceleration A=0 are smoothly changed at the switching position Z1. The position commands with the interval of the control period Ts which are time-serially aligned in parallel become the position command profile of the low speed driving region LS. For example, when the acceleration A=0 in the low speed driving region LS all the time, the position command profile in which the mounting nozzle 47 continues a constant speed extension movement at the low speed VL is obtained.

In the final step S7, the entire position command profile Zpr is created by linking the position command profiles of the coarse movement driving region LH and the low speed driving region LS. The position command portion 61 outputs the entire position command profile Zpr to the position control portion 62 and the torque control portion 63. At a point in time when the component P to be mounted is determined, the position command portion 61 can obtain and hold the position command profile Zpr by performing the above-described computation in advance. In other words, the position command portion 61 can be a prior computation unit of the present invention.

The position control portion 62 sequentially computes the position command Zcd which is necessary for every control period Ts by using the vibration control filter unit, based on the position command profile Zpr which is received from the position command portion 61. The vibration control filter unit of the position control portion 62 selectively attenuates the frequency component which includes the intrinsic frequency included in the position command profile Zpr, based on the intrinsic frequency of the vibration which is determined depending on the structures of the mounting nozzle 47, the nozzle holder 46, and the component mounting head 45. The intrinsic frequency of the vibration can be obtained, for example, by the actual measurement. The vibration control filter unit obtains the position command Zcd by performing the predetermined computation which corresponds to filter processing for every control period Ts. The position command Zcd is an amount which becomes a control target value of the feedback control portion 64 in a control step for every control period Ts. The position control portion 62 outputs the position command Zcd to a substracter 65 with the interval of the control period Ts.

Meanwhile, the torque control portion 63 performs torque conversion and generation of a feedforward torque command TQ1, based on the position command profile Zpr received from the position command portion 61. First, the torque conversion unit 631 of the torque control portion 63 converts the position command profile Zpr and computes an original command value of the torque for every control period Ts. This conversion computation is performed basically by a multiplication of inertia and a time differentiation computation in two stages.

Next, the vibration control filter unit 632 of the torque control portion 63 selectively attenuates the frequency component which includes the intrinsic frequency in the driving power (torque) of the Z-axis driving mechanism 49, by a computation technique which is similar to the vibration control filter unit of the position control portion 62. The original command value of the torque of the coarse movement driving region LH is time-serially input into the vibration control filter unit 632 in order from the torque conversion unit 631. The vibration control filter unit 632 obtains the feedforward torque command TQ1 by performing the predetermined computation which corresponds to the filter processing for every control period Ts, and outputs the feedforward torque command TQ1 to an adder 66 for every control period Ts. Therefore, the time-serial change of the feedforward torque command TQ1 is a result of performing the filter processing to the time-serial change of the original command value of the torque.

In addition, in the low speed driving region LS, it is also possible to use the vibration control filter unit as necessary.

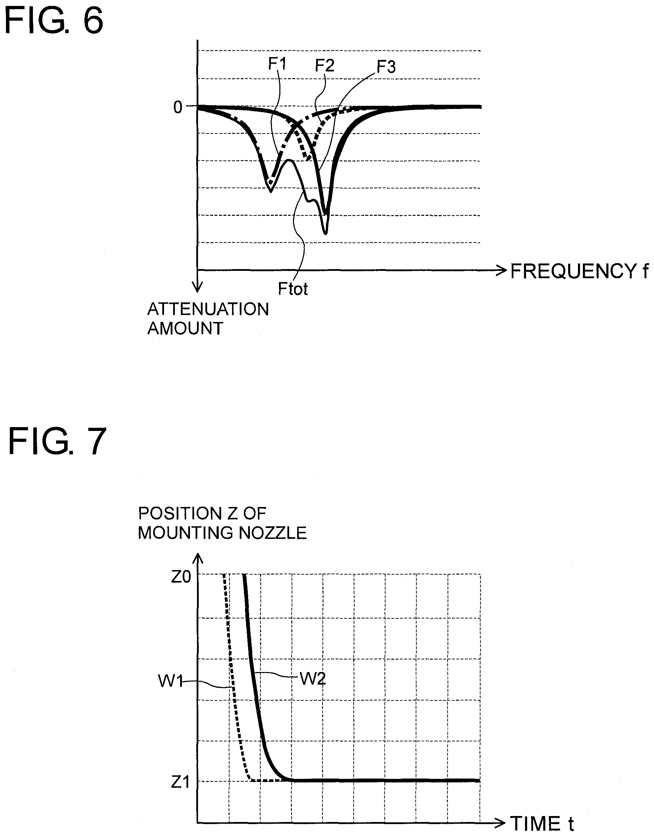

Specifically, the vibration control filter unit 632 of the position control portion 62 and the torque control portion 63 is realized by a digital computation type notch filter (band elimination filter). Fig. 6 is a view illustrating frequency properties of three types of vibration control filter units F1 to F3, and overall frequency properties Ftot when all of the three types are combined and used. Not being limited to these examples, it is possible to combine the above-described intrinsic frequency of the vibration, and to appropriately design the filter properties of the vibration control filter unit 632 of the position control portion 62 and the torque control portion 63. In addition, the vibration control filter unit 632 is not limited to the notch filter, and may be configured by appropriately combining a low pass filter and a high pass filter.

With reference to Fig. 3 again, the feedback control portion 64 is a unit for realizing a positioning waveform with the high accuracy in real time. As illustrated in the drawing, the current position Z of the mounting nozzle 47 which is driven by the Z-axis driving mechanism 49 is actually measured, and information of the current position Z is input as a feedback to a negative side terminal of a subtracter 65. Then, the position command Zcd which is output from the position control portion 62 is input into a positive side terminal of the subtracter 65. The subtracter 65 subtracts the current position Z from the position command Zcd, obtains a positional error ΔZ, and inputs the positional error Δz to the feedback control portion 64.

In the feedback control portion 64, for example, a known proportional-integral-differential control or a proportional-integral control can be employed. The feedback control portion 64 computes a feedback torque command TQ2 which reduces the positional error ΔZ, and inputs the feedback torque command TQ2 into the adder 66. In addition, the feedforward torque command TQ1 from the torque control portion 63 is input into the adder 66. By adding the feedforward torque command TQ1 and the feedback torque command TQ2, the adder 66 computes a final torque command TQ3 for obtaining desired acceleration A while reducing the positional error ΔZ, and inputs the final torque command TQ3 into the servo amplifier 67.

The servo amplifier 67 holds motor properties which are set in advance. The motor properties express a relationship between the torque of the servo motor which is used in the Z-axis driving mechanism 49 and the driving current. The servo amplifier 67 computes the driving current I from the final torque command TQ3 based on the motor properties, and outputs an actual driving current I to the servo motor.

By returning to the speed command profile of Fig. 4, the work control portion 6 starts the extension movement from the reference position Z0 of the mounting nozzle 47 at the time t0, and then, controls the extension movement at a high speed by rapidly increasing the extension speed V. Just before the mounting nozzle 47 approaches the switching position Z1, the work control portion 6 rapidly reduces the extension speed V of the mounting nozzle 47 to the level of an allowable speed Vav, and then, gradually mitigates reducing the speed. Accordingly, when the mounting nozzle 47 passes through the switching position Z1 at the time t1, the extension speed V becomes the low speed VL which is equal to or less than the allowable speed Vav.

In addition, at the switching position Z1, it is possible to set the extension speed V to be constant at the low speed VL, and to set the acceleration A to be zero. For this reason, after the mounting nozzle 47 passes through the switching position Z1, the extension speed V does not exceed the allowable speed Vav. Therefore, even if the working position Z2 changes within a range of the positions hH to hL when the printed circuit board K is curved, the extension speed V when the component P abuts against the printed circuit board K reliably becomes equal to or less than the allowable speed Vav.

In the embodiment, the coarse movement control unit and the low speed control unit are included to be dispersed in the position command portion 61, the position control portion 62, and the torque control portion 63.

Next, operations and effects of the vibration control filter unit 632 will be described. Fig. 7 is a waveform view illustrating a method of a basic experiment for confirming the effects of the vibration control filter unit 632 of the position control portion 62 and the torque control portion 63. In Fig. 7, a horizontal axis illustrates the time t, and a vertical axis illustrates the position Z of the mounting nozzle 47. In the basic experiment, a case where the mounting nozzle 47 is made to perform the extension movement from the reference position Z0 to the switching position Z1 and stopped is assumed, and a position command profile W1 is created by the position command portion 61. The position command profile W1 is input into the position control portion 62 and the torque control portion 63, and the vibration control filter unit 632 having the overall frequency properties Ftot is employed.

A graph illustrated by a dashed line of Fig. 7 illustrates the position command profile W1. In addition, a graph illustrated by a solid line of Fig. 7 illustrates a waveform W2 of the position command which is obtained by employing the vibration control filter unit in the position control portion 62. Even when the vibration control filter unit is employed, an inclination of the waveform W2 of the position command is not remarkably changed from the position command profile W1, and the inclination becomes slightly moderated as approaching the switching position Z1. In other words, the extension speed V which is commanded to the mounting nozzle 47 in the coarse movement driving region LH is not remarkably changed. In addition, the waveform W2 of the position command in the digital computation is temporally delayed than the position command profile W1, but damage is not generated because a delay amount is small.

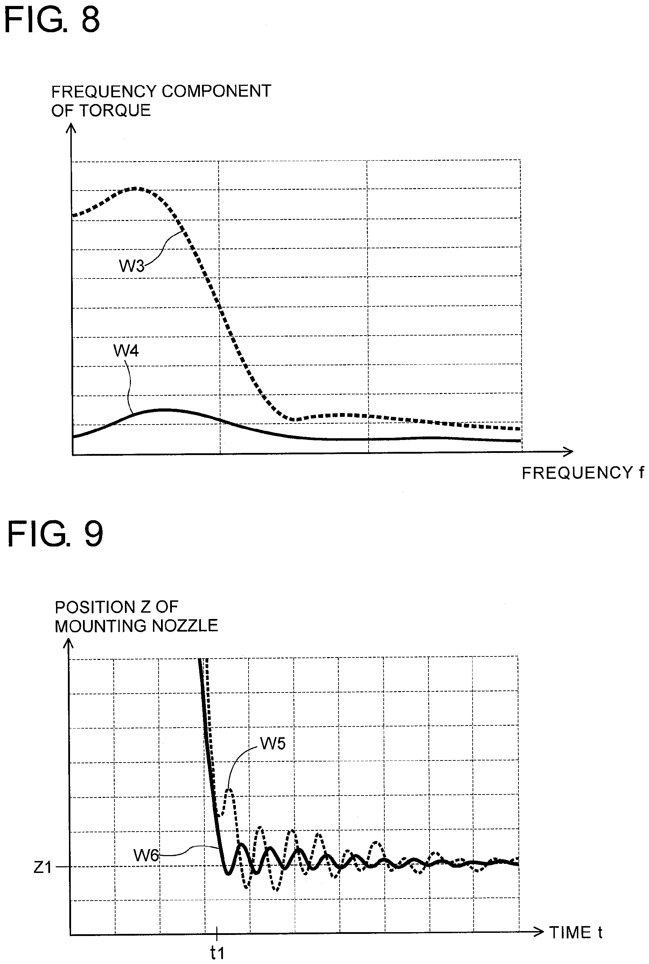

In addition, Fig. 8 is a frequency spectrum view illustrating an example of an operation of the vibration control filter unit 632 of the torque control portion 63. In Fig. 8, a horizontal axis illustrates a frequency f, and a vertical axis illustrates a size of the frequency component of the torque. A graph illustrated by a dashed line illustrates a frequency spectrum W3 which is included in the original command value of the torque converted from the position command profile W1. In addition, a graph illustrated by a solid line illustrates a frequency spectrum W4 which is included in the feedforward torque command TQ1 after the vibration control filter unit 632 is employed. In an example of Fig. 8, by employing the vibration control filter unit 632 of the overall frequency properties Ftot, a low frequency component of the original command value of the torque is greatly attenuated. In this manner, in the vibration control filter unit 632, it is possible to selectively attenuate the frequency component which includes the intrinsic frequency of the vibration.

Fig. 9 is a waveform view illustrating a result of the basic experiment for confirming the effects of the vibration control filter unit 632. In Fig. 9, a horizontal axis illustrates the time t, a vertical axis illustrates an actually measured value of the position Z of the mounting nozzle 47, and the vicinity of the switching position Z1 is enlarged compared to that in Fig. 7. A graph illustrated by a dashed line illustrates an actually measured value W5 of the position Z of the mounting nozzle 47 when the position control is performed based on the position command profile W1 of Fig. 7, that is, when the vibration control filter unit 632 is not employed. In addition, a graph which is illustrated by a solid line illustrates an actually measured value W6 of the position Z of the mounting nozzle 47 when the position control is performed based on the waveform W2 of Fig. 7, that is, when the vibration control filter unit 632 is employed.

The graph illustrated by the dashed line and the graph illustrated by the solid line vertically vibrate by considering the switching position Z1 as the center after the time t1. Here, an amplitude of the actually measured value W6 illustrated by the solid line becomes equal to or less than half of an amplitude of the actually measured value W5 illustrated by the dashed line. In other words, vibration of the mounting nozzle 47 can be suppressed by employing the vibration control filter unit 632.

In the component mounting machine 1 of the embodiment, the work control portion 6 sets the switching position Z1 in the middle of the stroke length LN in which the mounting nozzle 47 extends from the reference position Z0 to the working position Z2, and divides the switching position Z1 into the coarse movement driving region LH and the low speed driving region LS. Furthermore, the work control portion 6 controls the vibration while controlling the mounting nozzle 47 at a high speed in the coarse movement driving region LH, and makes the component P abut against the printed circuit board K after the speed becomes equal to or less than the allowable speed Vav while controlling the mounting nozzle 47 at the low speed VL in the low speed driving region LS. Furthermore, the work control portion 6 performs adjustment so that the extension speed V and the acceleration A when the mounting nozzle 47 passes through the switching position Z1 smoothly change. Therefore, it is possible to increase the average extension speed of the mounting nozzle 47, and to shorten the component mounting time.

In addition, since the extension speed V when the mounting nozzle 47 passes through the switching position Z1 is the low speed VL which is equal to or less than the allowable speed Vav, the extension speed V when the component P abuts against the printed circuit board K reliably becomes equal to or less than the allowable speed Vav. Accordingly, the impact load which is generated to the component P is reduced, and the component mounting work is also appropriately performed with respect to the low height component or the ultrathin component in which the allowable impact load or the positional error is stricter than that in the related art. Furthermore, in the coarse movement driving region LH, the vibration of the frequency component which includes the intrinsic frequency of the mounting nozzle 47 is considerably suppressed by the vibration control filter unit 632. In addition, at the switching position Z1, since the reaction force which is generated as the extension speed V and the acceleration A are smoothly changed is small, it is possible to more reliably ensure the accuracy of the working position without being influenced by the vibration.

In addition, the position command portion 61, which can compute and hold the position command profile Zpr in advance and use the position command profile Zpr in the control, is provided. Therefore, the computation for obtaining the position command profile Zpr after the mounting nozzle 47 starts the extension movement is not necessary, and a delay of the control due to the computation processing is not generated. In addition, the feedback control portion 64 which sets the position command profile Zpr to be the control target value and controls the feedback by actually measuring the current position Z of the mounting nozzle 47, is provided. A movement control with the high accuracy is performed by these overall actions.

In addition, the speed command profile illustrated in Fig. 4 is an example, and various examples can be employed in the speed command profile or the position command profile Zpr. In addition, the terminal control state unit or the vibration control filter unit which are described in the embodiment can also be appropriately changed. In addition to the description above, the present invention can be applied or modified in various manners.

### Reference Signs List

1: Component mounting machine (working apparatus)
2: Board conveyance device
3: Component supply device
4: Component transfer device
41: Head driving mechanism
45: Component mounting head
46: Nozzle holder (base member)
47: Mounting nozzle (working member)
49: Z-axis driving mechanism (driving portion)
5: Component camera
6: Work control portion
61: Position command portion (prior computation unit)
611: Switching setting unit
612: Switching adjustment unit
613: Terminal state control unit
62: Position control portion
63: Torque control portion
631: Torque conversion unit
632: Vibration control filter unit
64: Feedback control portion
67: Servo amplifier
K: Printed circuit board (working target)
P: Component
Z0: Reference position
Z1: Switching position
Z2: Working position
LN, LL: Stroke length
LH: Coarse movement driving region
LS: Low speed driving region

## Claims

1. A working apparatus (1), comprising:
a base member (46);
a working member (47) which is held by the base member (46) to be extendable, performs an extension movement from a reference position (Z0) of the base member (46), and performs a predetermined work by being abutted against a positioned working target (K) at a working position (Z2);
a driving portion (49) which outputs driving power and drives the extension movement of the working member (47); and
a work control portion (6) which controls a current position and an extension speed of the working member (47) to be variable by controlling the driving power of the driving portion (49),
wherein the work control portion (6) performs a feedforward control with respect to the driving power of the driving portion (49), and performs a feedback control by comparing and checking the current position (Z) of the working member (47) with a position command (Zcd),
wherein the work control portion (6) includes
a switching setting unit (611) which sets a switching position (Z1) in the middle of a stroke length of which the working member (47) extends to the working position (Z2) from the reference position (Z0), and sets a coarse movement driving region (LH) from the reference position (Z0) to the switching position (Z1) and a low speed driving region (LS) from the switching position (Z1) to the working position (Z2),
a coarse movement control unit which controls vibration generated by at least one of the working member (47) and the base member (46) by a reaction force when the working member (47) performs the extension movement while controlling the extension speed of the working member (47) to be high in the coarse movement driving region (LH),
a low speed control unit which controls the working member (47) to extend to the working position (Z2) after the speed becomes equal to or less than an allowable speed that is appropriate for the predetermined work while controlling the extension speed of the working member (47) to be low in the low speed driving region (LS), and
a switching adjustment unit (612) which adjusts the extension speed and acceleration of the working member (47) to be smoothly changed when the working member (47) passes through the switching position (Z1),
an adder (66) which receives a feedforward torque command (TQ1) and a feedback torque command (TQ2) and computes a final torque command (TQ3) for the driving portion (49),
further wherein, the coarse movement control unit includes a terminal state control unit (613), or a linear matrix inequality unit, which controls the extension speed and the acceleration when the working member (47) passes through the switching position (Z1) to match the switching value and computes a torque value in the coarse movement driving region (LH),
the coarse movement control unit includes a vibration control filter unit (632) that selectively attenuates a frequency component including the intrinsic frequency in the driving power of the driving portion (49) based on an intrinsic frequency of the vibration which is determined depending on a structure of the working member (47) and the base member (46), and
the switching adjustment unit (612) sets in advance a switching value, which delivers the extension speed and the acceleration when the working member (47) passes through the switching position (Z1), from the coarse movement control unit to the low speed control unit.

2. The working apparatus (1) according to claim 1,
wherein the switching adjustment unit (612) sets the extension speed when the working member (47) passes through the switching position (Z1) to be equal to or less than the allowable speed.

3. The working apparatus (1) according to claim 1 or 2,
wherein the work control portion (6) further includes a prior computation unit (61) which is determined by the switching setting unit (611), the coarse movement control unit, the low speed control unit, and the switching adjustment unit (612), computes and holds at least one of a position command profile which shows a relationship between elapsed time after the working member (47) starts the extension movement and the current position of the working member (47), and a speed command profile which shows a relationship between the elapsed time and the extension speed of the working member (47) in advance, and uses the profiles in performing a control.

4. A component mounting machine (1) comprising the working apparatus according to any one of claims 1 to 3, and comprising:
a board holding device which positions and holds a printed circuit board (K);
a component supply device (3) which supplies a plurality of components (P); and
a component transfer device (4) which includes a mounting nozzle (47) which sucks the component (P) from the component supply device (3) and mounts the component (P) on the held printed circuit board (K), a nozzle holder (46) which holds the mounting nozzle (47) to be able to perform the extension movement, and a nozzle driving mechanism which drives the extension movement of the mounting nozzle (47),
wherein the nozzle holder (46) corresponds to the base member (46), the mounting nozzle (47) corresponds to the working member (47), and the nozzle driving mechanism corresponds to the driving portion (49), and
wherein, by considering the working target (K) as the held printed circuit board (K) and the working position (Z2) as a surface of the printed circuit board (K), the predetermined work is a component mounting work in which the mounting nozzle (47) abuts against the surface of the positioned printed circuit board and mounts the component (P).

5. The component mounting machine (1) according to claim 4,
wherein the switching setting unit (611) sets the switching position (Z1) at a working position (Z2) when the stroke length becomes minimized in consideration of the stroke length which changes depending on at least one of a component height dimension that is different according to the type of the component (P) and deformation of the positioned printed circuit board (K).

## Patentansprüche

1. Arbeitsvorrichtung (1), umfassend:
ein Trägerelement (46);
ein Arbeitselement (47), das von dem Trägerelement (46) so gehalten wird, dass es ausfahrbar ist, das eine Ausfahrbewegung von einer Bezugsposition (Z0) des Trägerelements (46) durchführt, und eine vorbestimmte Arbeit durchführt, indem es an ein positioniertes Arbeitsziel (K) an einer Arbeitsposition (Z2) angrenzt;
einen Antriebsabschnitt (49), der Antriebsenergie abgibt und die Ausfahrbewegung des Arbeitselements (47) antreibt; und
einen Arbeitssteuerbereich (6), der eine aktuelle Position steuert und eine Ausfahrgeschwindigkeit des Arbeitselements (47) durch die Steuerung der Antriebsenergie des Antriebsabschnitts (49) so steuert, dass sie variabel ist,
wobei der Arbeitssteuerbereich (6) eine Vorsteuerung in Bezug auf die Antriebsenergie des Antriebsabschnitts (49) durchführt und durch Vergleichen und Überprüfen der aktuellen Position (Z) des Arbeitselements (47) mit einem Positionsbefehl (Zcd) eine Rückkopplungssteuerung durchführt,
wobei der Arbeitssteuerbereich (6) einschließt:
eine Schalteinstelleinheit (611), die eine Schaltposition (Z1) in der Mitte einer Hublänge, von der sich das Arbeitselement (47) von der Bezugsposition (Z0) zu der Arbeitsposition (Z2) erstreckt, einstellt, und einen Grobbewegungs-Antriebsbereich (LH) von der Bezugsposition (Z0) zu der Schaltposition (Z1) und einen Niedergeschwindigkeits-Antriebsbereich (LS) von der Schaltposition (Z1) zu der Arbeitsposition (Z2) einstellt,
eine Grobbewegungs-Steuereinheit, die die Vibration steuert, die von dem Arbeitselement (47) und/oder dem Trägerelement (46) durch eine Reaktionskraft erzeugt wird, wenn das Arbeitselement (47) die Ausfahrbewegung durchführt, wobei die Ausfahrgeschwindigkeit des Arbeitselements (47) in dem Grobbewegungsbereich (LH) so eingestellt wird, dass sie hoch ist,
eine Niedergeschwindigkeits-Steuereinheit, die das Arbeitselement (47) so steuert, dass es sich zu der Arbeitsposition (Z2) ausdehnt, nachdem die Geschwindigkeit gleich oder kleiner als eine zulässige Geschwindigkeit geworden ist, die für die vorgegebene Arbeit geeignet ist, wobei die Ausfahrgeschwindigkeit des Arbeitselements (47) so gesteuert wird, dass sie in dem Niedergeschwindigkeits-Antriebsbereich (LS) niedrig ist, und
eine Schaltanpassungseinheit (612), die die Ausfahrgeschwindigkeit und die Beschleunigung des Arbeitselementes (47) so einstellt, dass sie reibungslos verändert werden können, wenn das Arbeitselement (47) die Schaltposition (Z1) passiert,
einen Addierer (66), der einen Vorsteuerungs-Drehmomentbefehl (TQ1) und einen Rückkopplungs-Drehmomentbefehl (TQ2) empfängt und einen endgültigen Drehmomentbefehl (TQ3) für den Antriebsbereich (49) berechnet,
wobei des Weiteren die Grobbewegungs-Steuereinheit eine Endzustands-Steuereinheit (613) oder eine Linearmatrix-Ungleichungseinheit einschließt, die die Ausfahrgeschwindigkeit und die Beschleunigung steuert, wenn das Arbeitselement (47) die Schaltposition (Z1) passiert, um den Schaltwert anzupassen, und einen Drehmomentwert in dem Grobbewegungs-Antriebsbereich (LH) zu berechnen,
wobei die Grobbewegungs-Steuereinheit eine Vibrationssteuerungs-Filtereinheit (632) einschließt, die selektiv eine Frequenzkomponente dämpft, die die Eigenfrequenz in der Antriebsenergie des Antriebbereichs (49), basierend auf einer Eigenfrequenz der Vibration einschließt, die in Abhängigkeit von der Struktur des Arbeitselements (47) und des Trägerelements (46) ermittelt wird, und
wobei die Schaltanpassungseinheit (612) im Voraus einen Schaltwert einstellt, der die Ausfahrgeschwindigkeit und die Beschleunigung liefert, wenn das Arbeitselement (47) die Schaltposition (Z1), von der Grobbewegungs-Steuereinheit zu der Niedergeschwindigkeits-Steuereinheit, passiert.

2. Arbeitsvorrichtung (1) nach Anspruch 1,
wobei die Schaltanpassungseinheit (612) die Ausfahrgeschwindigkeit so einstellt, dass sie gleich oder kleiner als die zulässige Geschwindigkeit ist, wenn das Arbeitselement (47) die Schaltposition (Z1) passiert.

3. Arbeitsvorrichtung (1) nach Anspruch 1 oder Anspruch 2,
wobei der Arbeitssteuerabschnitt (6) des Weiteren eine Vorrecheneinheit (61) einschließt, die durch die Schalteinstelleinheit (611), die Grobbewegungs-Steuereinheit, die Niedergeschwindigkeit-Steuereinheit und die Schaltanpassungseinheit (612) festgelegt ist, ein Positionsbefehlsprofil, das die Beziehung zwischen der verstrichenen Zeit, nachdem das Arbeitselement (47) die Ausfahrbewegung beginnt, und der aktuellen Position des Arbeitselements (47) anzeigt, und/oder ein Geschwindigkeitsbefehlsprofil, das die Beziehung zwischen der verstrichenen Zeit und der Ausfahrgeschwindigkeit des Arbeitselements (47) anzeigt, im Voraus berechnet und enthält, und die Profile bei der Durchführung einer Steuerung anwendet.

4. Komponentenmontagevorrichtung (1), die die Arbeitsvorrichtung nach einem der Ansprüche 1 bis 3 umfasst, und umfasst:
eine Leiterplatten-Haltevorrichtung, die eine gedruckte Leiterplatte (K) positioniert und festhält;
eine Komponentenzuführvorrichtung (3), die eine Vielzahl an Komponenten (P) zuführt; und
eine Komponentenübertragungsvorrichtung (4), die eine Montagedüse (47) einschließt, die die Komponente (P) von der Komponentenzuführvorrichtung (3) ansaugt und die Komponente (P) auf die festgehaltene gedruckte Leiterplatte (K) montiert, eine Düsenhalterung (46), die die Montagedüse (47) festhält, um in der Lage zu sein, die Ausfahrbewegung durchzuführen, und einen Düsenantriebmechanismus, der die Ausfahrbewegung der Montagedüse (47) antreibt,
wobei die Düsenhalterung (46) dem Trägerelement (46) entspricht, die Montagedüse (47) dem Arbeitselement (47) entspricht, und der Düsenantriebsmechanismus dem Antriebsabschnitt (49) entspricht, und
wobei, bei einer Betrachtung der gehaltenen gedruckten Leiterplatte (K) als das Arbeitsziel (K) und der Oberfläche der gedruckten Leiterplatte (K) als der Arbeitsposition (Z2) die vorgegebene Arbeit eine Komponentenmontagearbeit ist, in der die Montagedüse (47) an die Oberfläche der positionierten gedruckten Leiterplatte angrenzt und die Komponente (P) montiert.

5. Komponentenmontagevorrichtung (1) nach Anspruch 4,
wobei die Schalteinstelleinheit (611) die Schaltposition (Z1) an einer Arbeitsposition (Z2) einstellt, wenn die Hublänge unter Berücksichtigung einer Hublänge minimiert wird, die sich in Abhängigkeit von einer Komponentenhöhendimension, die je nach Typ der Komponente (P) unterschiedlich ist, und/oder einer Deformation der positionierten gedruckten Leiterplatte (K) ändert.

## Revendications

1. Appareil de travail (1), comprenant:
un élément de base (46);
un élément de travail (47) qui est maintenu par l'élément de base (46) pour être extensible, qui exécute un mouvement d'extension à partir d'une position de référence (Z0) de l'élément de base (46) et qui exécute une tâche prédéterminée en étant en butée contre une cible de travail (K) positionnée en position de travail (Z2);
une partie d'entraînement (49) qui fournit une puissance d'entraînement et entraîne le mouvement d'extension de l'élément de travail (47); et
une partie de commande de travail (6) qui commande une position actuelle et une vitesse d'extension de l'élément de travail (47) pour qu'elle soit variable, en jouant sur la puissance d'entraînement de la partie d'entraînement (49),
dans lequel la partie de commande de travail (6) effectue une commande d'avance par rapport à la puissance d'entraînement de la partie d'entraînement (49) et effectue une commande de rétroaction en comparant et en vérifiant la position actuelle (Z) de l'élément de travail (47) avec une commande de position (Zed).
dans lequel la partie de commande de travail (6) inclut
une unité de réglage de commutation (611) qui définit une position de commutation (Z1) au milieu d'une longueur de course, dont l'élément de travail (47) se déploie vers la position de travail (Z2) à partir de la position de référence (Z0), et définit une zone d'entraînement de mouvement approximatif (LH), de la position de référence (ZO) vers la position de commutation (Z1) et une zone d'entraînement à faible vitesse (LS), de la position de commutation (Z1) vers la position de travail (Z2),
une unité de commande de mouvement approximatif qui contrôle les vibrations générées par au moins l'un de l'élément de travail (47) et de l'élément de base (46) par une force de réaction lorsque l'élément de travail (47) effectue le mouvement d'extension tout en augmentant la vitesse d'extension de l'élément de travail (47) dans la zone d'entraînement de mouvement approximatif (LH),
une unité de commande à faible vitesse qui commande l'extension de l'élément de travail (47) jusqu'à la position de travail (Z2) une fois que la vitesse est égale ou inférieure à une vitesse admissible et convenant au travail prédéterminé tout en contrôlant la vitesse d'extension de l'élément de travail (47) pour qu'elle reste faible dans la zone d'entraînement à faible vitesse (LS), et
une unité de réglage de commutation (612) qui règle la vitesse d'extension et l'accélération de l'élément de travail (47) pour assurer un changement en douceur lorsque l'élément de travail (47) passe par la position de commutation (Z1),
un additionneur (66) qui reçoit une commande de couple d'avance (TQ1) et une commande de couple de rétroaction (TQ2) et qui calcule une commande de couple final (TQ3) pour la partie d'entraînement (49),
dans lequel en outre, l'unité de commande de mouvement approximatif inclut une unité de commande d'état terminal (613), ou une unité d'inégalité de matrice linéaire, qui commande la vitesse d'extension et l'accélération lorsque l'élément de travail (47) passe par la position de commutation (Z1) pour correspondre à la valeur de commutation et calcule une valeur de couple dans la zone d'entraînement de mouvement approximatif (LH),
l'unité de commande de mouvement approximatif comprend une unité de filtrage de contrôle de vibration (632) qui atténue sélectivement une composante de fréquence incluant la fréquence intrinsèque dans la puissance d'entraînement de la partie d'entraînement (49) en fonction d'une fréquence intrinsèque de la vibration qui est déterminée en fonction d'une structure de l'élément de travail (47) et de l'élément de base (46), et
l'unité de réglage de commutation (612) fixe à l'avance une valeur de commutation, qui fournit la vitesse d'extension et l'accélération, lorsque l'élément de travail (47) passe par la position de commutation (Z1), de l'unité de commande de mouvement approximatif à l'unité de commande à faible vitesse.

2. Appareil de travail (1) selon la revendication 1,
dans lequel l'unité de réglage de commutation (612) règle la vitesse d'extension lorsque l'élément de travail (47) passe par la position de commutation (Z1), pour que ladite vitesse d'extension soit égale ou inférieure à la vitesse admissible.

3. Appareil de travail (1) selon la revendication 1 ou la revendication 2,
dans lequel la partie de commande de travail (6) inclut en outre une unité de calcul préalable (61) qui est déterminée par l'unité de réglage de commutation (611), l'unité de commande de mouvement approximatif, l'unité de commande de faible vitesse et l'unité de réglage de commutation (612), calcule et maintient au moins un profil de commande de position qui indique une rotation entre le temps écoulé après que l'élément de travail (47) démarre le mouvement d'extension et la position actuelle de l'élément de travail (47) et un profil de commande de vitesse qui indique une rotation entre le temps écoulé et la vitesse d'extension de l'élément de travail (47) à l'avance, et utilise les profils dans l'exécution d'un contrôle.

4. Machine de montage de composants (1) comprenant l'appareil de travail selon l'une quelconque des revendications 1 à 3, et comprenant:
un dispositif de maintien de carte qui positionne et maintient une carte de circuit imprimé (K);
un dispositif d'alimentation de composants (3) qui fournit une pluralité de composants (P); et
un dispositif de transfert de composants (4) qui comprend une buse de montage (47) qui aspire le composant (P) à partir du dispositif d'alimentation de composants (3) et pose le composant (P) sur la carte de circuit imprimé maintenue en place (K), un support de buse (46) qui maintient la buse de montage en place (47) pour qu'elle puisse effectuer le mouvement d'extension, et un mécanisme d'entraînement de buse qui entraîne le mouvement d'extension de la buse de montage (47),
dans lequel, en considérant la cible de travail (K) comme carte de circuit imprimé maintenue en place (K) et la position de travail (Z2) comme surface de la carte de circuit imprimé (K), le travail prédéterminé est un travail de montage de composant dans lequel la buse de montage (47) est en butée contre la surface de la carte de circuit imprimé positionnée et pose le composant (P).

5. Machine de montage de composants (1) selon la revendication 4,
dans lequel l'unité de réglage de commutation (611) règle la position de commutation (Z1) à une position de travail (Z2) lorsque la longueur de course diminue par rapport à la longueur de course qui change en fonction d'au moins une dimension de hauteur de composant qui est différente selon le type de composant (P) et la déformation de la carte de circuit imprimé positionnée (K).
